# EUROPEAN PATENT SPECIFICATION

(11) **EP 2 428 541 B1**
(45) Date of publication and mention of the grant of the patent: **06.03.2019**
(21) Application number: 11179985.4
(22) Date of filing: 05.09.2011
(51) Int. Cl.: C09K 3/14, C09G 1/02, H01L 21/3105, C09K 13/00

(54) **Aqueous polishing composition and process for chemically mechanically polishing substrates containing silicon oxide dielectric and polysilicon films**
Wässrige Polierzusammensetzung und Verfahren zum chemisch-mechanischen Polieren von Substraten mit dielektrischen Siliciumoxid- und Polysiliciumfilmen
Composition aqueuse de polissage et procédé de polissage mécanique chimique de substrats contenant des films diélectriques en oxyde de silicium et polysilicone

(30) Priority: 08.09.2010 US 380719 P
(43) Date of publication of application: 14.03.2012
(73) Proprietor: BASF SE, 67056 Ludwigshafen am Rhein (DE)
(72) Inventor: Li, Yuzhuo, 69123 Heidelberg (DE); Chu, Jea-Ju, Shilin District, Taipei City 111 (TW); Venkataraman, Shyam Sundar, Zhongli City Taoyuan County 320 (TW); Chiu, Wei Lan William, Taipei City (TW); Pinder, Harvey Wayne, Chicago, IL 60659 (US)
(74) Representative: BASF IP Association

(56) References cited:
- EP-A1- 1 747 849
- EP-A1- 2 131 389
- US-A1- 2009 035 202
- US-B1- 6 270 393

## Description

Aqueous Polishing Composition and Process for Chemically Mechanically Polishing Substrates Containing Silicon Oxide Dielectric and Polysilicon Films.

The present invention is directed to a novel aqueous polishing composition which is particularly suitable for polishing semiconductor substrates containing silicon oxide dielectric and polysilicon films, optionally containing silicon nitride films.

Moreover, the present invention is directed to a novel process for polishing substrates for manufacturing electrical, mechanical and optical devices, the said substrate materials containing silicon oxide and polysilicon films, optionally containing silicon nitride films.

### Background of the Invention

Chemical mechanical planarization or polishing (CMP) is the primary process to achieve local and global planarity of integrated circuits (ICs) devices. The technique typically applies CMP compositions or slurries containing abrasives and other additives as an active chemistry between a rotating substrate surface and a polishing pad under an applied load. Thus, the CMP process couples a physical process such as abrasion with a chemical process such as oxidation or chelation. It is not desirable for the removal or polishing of substrate materials to be comprised of purely physical or purely chemical action, but rather the synergistic combination of both in order to achieve a fast uniform removal.

This way, the substrate material is removed until the desired planarity is achieved or a barrier sublayer or stopping layer is exposed. Ultimately, a planar, defect-free surface is obtained which enables proper multilayer IC device fabrication by subsequent photolithography, patterning, etching and thin-film processing.

Shallow trench isolation (STI) is a specific CMP application which generally requires the selective removal of silicon dioxide to silicon nitride on a patterned wafer substrate. In this case, etched trenches are overfilled with a dielectric material, e.g., silicon dioxide, which is polished using the silicon nitride barrier film as the stopping layer. The CMP process ends with clearing the silicon dioxide from the barrier film while minimizing the removal of exposed silicon nitride and trench silicon oxide.

This requires CMP slurries capable of achieving a high relative ratio of silicon dioxide material removal rate MRR to silicon nitride removal rate MRR which ratio is also referred to in the art as oxide-to-nitride selectivity.

Recently, polysilicon films are also used as barrier films or as an electrode material (cf. the American patent US 6,626,968 B2). Therefore, it has become highly desirable to have CMP slurries and methods available which allow for the global planarization of substrates containing silicon oxide dielectric and polysilicon films. This requires CMP slurries exhibiting a high oxide-to-polysilicon selectivity.

It is even more desirable to have CMP slurries and methods available which allow for the global planarization of substrates additionally containing silicon nitride films.

In this case, the oxide-to-nitride selectivity should not be too high, in order to avoid dishing, and other damages and defects in the globally planarized, heterogeneous, patterned surface containing silicon oxide, silicon nitride and polysilicon areas. However, the silicon nitride-to-polysilicon selectivity should also be high.

Ceria-based CMP slurries have received considerable attention in STI applications because of their ability to achieve a comparatively high oxide-to-nitride selectivity due to the high chemical affinity of ceria to silicon dioxide which is also referred to in the art as the chemical tooth action of ceria.

Nevertheless, the oxide-to-polysilicon selectivity of ceria-based CMP slurries must be improved by additives which "tailor" the selectivity.

Numerous attempts have been made to tailor the selectivity of ceria-based CMP slurries.

Thus, Jae-Don Lee et al. disclose in Journal of the Electrochemical Society, 149 (8), G477-G481, 2002, the effects of nonionic surfactants with different hydrophile-lipophile-balance (HLB) values such as polyethyleneoxides, ethyleneoxide-propyleneoxide copolymers and ethyleneoxide-propyleneoxide-ethyleneoxide triblock copolymers on oxide-to-polysilicon selectivity during CMP. However, fumed silica is used as the abrasive.

P. W. Carter et al. disclose in Electrochemical and Solid-State Letters, 8 (8) G218-G221 (2005), Interfacial Reactivity between Ceria and Silicon Dioxide and Silicon Nitride Surfaces, Organic Additive Effects, the influence of glutamic acid, picolinic acid, 4-hydroxybenzoic acid, imidazole, acetic acid, formic acid, 3-hydroxypicolinic acid, anthranilic acid, pyrrole carboxylic acid, cyclohexane carboxylic acid, piperazine, pyridine, 2-phenylacetic acid, benzoic acid, 3-aminophenol, succinic acid, betain, glycine, proline, benzenesulfonic acid, morpholine, salicylic acid, terephthalic acid, malic acid, isopropanol, citric acid and oxalic acid on the oxide-to-nitride selectivity.

Y. N. Prasad et al. disclose in Electrochemical and Solid-State Letters, 9 (12) G337-G339 (2006), Role of Amino-Acid Absorption on Silica and Silicon Nitride Surfaces during STI CMP, the influence of proline and arginine.
Hyun-Goo Kang et al. disclose in Journal of Material Research, volume 22, No. 3, 2007, pages 777 to 787, the effects of abrasive particles size and molecular weight of poly(acrylic acid) in ceria slurry on removal selectivity of SiO₂/Si₃N₄ films in shallow trench isolation chemical mechanical planarization.

S. Kim et al. disclose in Journal of Colloid and Interface Science, 319 (2008), pages 48 to 52, the absorption behavior of anionic polyelectrolyte for chemical mechanical polishing (CMP).

S. V. Babu et al., Electrochemical and Solid-State Letters, 7 (12) G327-G330 (2004), Slurry Additive Effects on the Suppression of Silicon Nitride Removal during CMP, investigated the influence of arginine, lysine, proline, N-methylglycine, alanine, glycine, picolinic acid, N,N-dimethylglycine, 3-aminobutyric acid and isonicotinic acid.

Jae-Dong Lee et al. disclose in Journal of the Electrochemical Society, 149 (8) G477-G481, 2002, Effects of Nonionic Surfactants on Oxide-To-Polysilicon Selectivity during Chemical Mechanical Polishing, the influence of surfactants such as polyethylene oxide (PEO) and ethyleneoxide-propyleneoxide-ethyleneoxide triblock copolymers on the selectivity. However, the oxide-to-nitride selectivity is not addressed.

The American patent US 5,738,800, US 6, 042, 741, US 6,132,637 and US 6,218,305 B disclose a ceria-based CMP slurry containing complexing agents such as malic acid, tartaric acid, gluconic acid, citric acid, ortho di- and polyhydroxybenzoic acids, phthalic acid, pyrocathechol, pyrogallol, gallic acid, tannic acid and their salts. Moreover, the ceria-based CMP slurry contains an anionic, cationic, amphoteric or nonionic surfactant The ceria-based CMP slurry is claimed to have a high oxide-to-nitride selectivity.

The American patents US 5,759,917, US 6,689,692 B1 and US 6,984,588 B2 disclose a ceria-based CMP slurry containing a carboxylic acid such as acetic acid, adipic acid, butyric acid, capric acid, caproic acid, caprylic acid, citric acid, glutaric acid, glycolic acid, formic acid, fumaric acid, lactic acid, lauric acid, malic acid, maleic acid, malonic acid, myristic acid, oxalic acid, palmitic acid, phthalic acid, propionic acid, pyruvic acid, stearic acid, succinic acid, tartaric acid, valeric acid, 2-(2-methoxyethoxy) acetic acid, 2-[2-(2-methoxyethoxy)ethoxy] acetic acid, poly(ethylene glycol)bis(carboxymethyl)ether and their derivatives and salts. In addition, the ceria-based CMP slurry contains water-soluble organic and inorganic salts such as nitrates, phosphates and sulfates. The ceria-based CMP slurry is claimed to polish a silicon oxide overfill in preference to a silicon nitride layer.

The American patent US 6,299,659 B1 discloses a ceria-based CMP slurry wherein the abrasive particles have been treated with a silane, titanate, circonate, aluminum and phosphate coupling agent in order to improve the oxide-to-nitride selectivity.

The American patent application US 2002/0034875 A1 and the American patent US 6,626,968 B2 disclose a ceria-based CMP slurry containing surfactants, pH adjusting agents such as potassium hydroxide, sulfuric acid, nitric acid, hydrochloric acid or phosphoric acid, and polymers containing a hydrophilic functional group and a hydrophobic functional group such as polyvinyl methyl ether (PVME), polyethylene glycol (PEG), polyoxyethylene 23 lauryl ether (POLE), polypropanoic acid (PPA), polyacrylic acid (PM), and polyether glycol bis ether (PEGBE). The ceria-based CMP slurry increases the oxide-to-polysilicon selectivity.

The American patent US 6,436,835 B1 discloses a ceria-based CMP slurry for the shallow trench isolation process comprising water-soluble organic compounds having carboxylic acid or carboxylate or sulfonic acid or sulfamic groups such as polyacrylic acid, polymethacrylic acid, naphthalene sulfonic acid-formalin condensate, malic acid, lactic acid, tartaric acid, gluconic acid, citric acid, succinic acid, adipic acid, fumaric acid, aspartic acid, glutamic acid, glycine 4-aminobutyric acid, 6-aminohexanoic acid, 12-aminolauric acid, arginine, glycylglycine, laurylbenzene sulfonic acid and their ammonium salts. The ceria-based CMP slurry is claimed to have a high oxide-to-nitride selectivity.

The American patents US 6,491,843 B1, US 6,544,892 B2 and US 6,627,107 B2 disclose a ceria-based CMP slurry containing alpha-amino acids such as lysine, alanine, and proline for improving the oxide-to-nitride selectivity.

The American patent US 6,616,514 B1 discloses a ceria-based CMP slurry containing organic polyols having at least 3 hydroxyl groups that are not dissociable in the aqueous medium; or a polymer formed from at least one monomer having at least 3 hydroxyl groups that are not dissociable in the aqueous medium such as mannitol, sorbitol, mannose, xylitol, sorbose, sucrose, and dextrin for improving the oxide-to-nitride selectivity.

The American patent US 7,071,105 B2 and the American application US 2006/0144824 A1 disclose a ceria-based CMP slurry containing a polishing additive comprising functional groups having a pKa of 4 to 9. The polishing additive is selected from the group consisting of arylamines, aminoalcohols, aliphatic amines, heterocyclic amines, hydroxamic acids, aminocarboxylic acids, cyclic monocarboxylic acids, unsaturated monocarboxylic acids, substituted phenols, sulfonamides, thiols and salts thereof, in particular, chlorides, bromides, sulfates, sulfonates, trifluoromethyl sulfonates, acetates, trifluoroacetates, picrates, perfluorobutyrates as well as sodium, potassium and ammonium salts.

The arylamines expressly mentioned are aniline, 4-chloroaniline, 3-methoxyaniline, N-methylaniline, 4-methoxyaniline, p-toluidine, anthranilic acid, 3-amino-4-hydroxybenzenesulfonic acid, aminobenzylalcohol, aminobenzylamine, 1-(-aminophenyl)pyrrole, 1-(3-aminophenyl)ethanol, 2-aminophenyl ether, 2,5-bis-(4-aminophenyl)-1,3,4-oxidadiazole, 2-(2-aminophenyl)-1H-1,3,4-triazole, 2-aminophenyl, 3-aminophenyl, 4-aminophenyl, dimethylaminophenol, 2-aminothiolphenol, 3-aminothiolphenol, 4-aminophenyl methyl sulfide, 2-aminobenzenesulfonamide, orthanilic acid, 3-aminobenzene boronic acid, 5-aminoisophthalic acid, sulfacetamide, sulfanilic acid,o- or p-arsanilic acid, and(3R)-3-(4-trifluoromethylphenylamino) pentanoic acid.

The aminoalcohols expressly mentioned are triethanolamine, benzyldiethanolamine, tris(hydroxylmethyl)aminomethane, hydroxylamine, and tetracycline.

The aliphatic amines expressly mentioned are methoxyamine, hydroxylamine, N-methylhydroxylamine, N,O-dimethylhydroxylamine, beta-difluoroethylamine, ethylenediamine, triethylenediamine, diethyl((butylamino)(2-hydroxyphenyl)methyl)phosphonate, iminoethanes, iminobutanes, triallylamine, cyanoamines such as aminoacetonitrile, dimethylaminoacetonitrile, 2-amino-2-cyanopropane, isopropylaminopropionitrile, diethylaminopropionitrile, aminopropionitrile, dicyanodiethylamine), hydrazine, methylhydrazine, tetramethylhydrazine, N,N-dimethylhydrazine, phenylhydrazine, N,N-diethylhydrazine, trimethylhydrazine, ethylhydrazine and salts thereof.

The heterocyclic amines expressly mentioned are imidazole, 1-methylimidazole, 2-methylimidazole, 2-ethylimidazole, 2-hydroxylmethylimidazole, 1-methyl-2-hydroxylmethylimidazole, benzoimidazole, quinoline, isoquinoline, hydroxyquinoline, melamine, pyridine, bipyridine, 2-methylpyridine, 4-methylpyridine, 2-aminopyridine, 3-aminopyridine, 2,3-pyridinedicarboxylic acid, 2,5-pyridinedicarboxylic acid, 2,6-pyridinedicarboxylic acid, 5-butyl-2-pyridinecarboxylic acid,, 2-pyridinecarboxylic acid, 3-hydroxy-2-pyridinecarboxylic acid, 4-hydroxy-2-pyridinecarboxylic acid, 3-benzoyl-2-pyridinecarboxylic acid, 6-methyl-2-pyridinecarboxylic acid, 3-methyl-2-pyridinecarboxylic acid, 6-bromo-2-pyridinecarboxylic acid, 6-chloro-2-pyridinecarboxylic acid, 3,6-dichloro-2-pyridinecarboxylic acid, 4-hydrazino-3,5,6-trichloro-2-pyridinecarboxylic acid, 2-quinolinecarboxylic acid, 4-methoxy-2-quinolinecarboxylic acid, 8-hydroxy-2-quinolinecarboxylic acid, 4,8-hydroxy-2-quinolinecarboxylic acid, 7-chloro-4-hydroxy-2-quinolinecarboxylic acid, 5,7-dichloro-4-hydroxy-2-quinolinecarboxylic acid, 5-nitro-2-quinolinecarboxylic acid, 1-isoquinolinecarboxylic acid, 3-isoquinolinecarboxylic acid, acridine, benzoquinoline, benzacridine, clonidine, anabasine, nornicotine, triazolopyridine, pyridoxine, serotonin, histamine, benzodiazepine, aziridine, morpholine, 1,8-diazabicyclo(5,4,0)undecene-7 DABCO, hexamethylenetetramine, piperazine, N-benzoylpiperazine, 1-tosylpiperazine,N-carboxyethylpiperazine,1,2,3-triazole, 1,2,4-triazole, 2-aminothiazole, pyrrole, pyrrole-2-carboxylic acid, 3-pyrroline-2-carboxylic acid, ethylpyrroline, cyclohexylpyrroline, tolylpyrroline, tetrazole, 5-cyclopropyltetrazole, 5-hydroxytetrazole, 5-phenoxytetrazole, 5-phenyltetrazole, fluorouracil, methylthiouracil, 5,5-diphenylhydantoin, 5,5-dimethyl-2,4-oxazolidinedione, phthalimide, succinimide, 3,3-methylphenylglutarimide, 3,3-dimethylsuccinimide, imidazol[2,3-b] thioxazole, hydroxyemidazo[2,3-a]isoindole, 5,5-methylphenylbarbituric acid, 1,5,5-trimethylbarbituric acid, hexobarbital, 5,5-dimethylbarbituric acid, 1,5-dimethyl-5-phenylbarbituric acid and their salts.

The hydroxamic acids specifically mentioned are formohydroxamic acid, acetohydroxamic acid, benzohydroxamic acid, salicylhydroxamic acid, 2-aminobenzohydroxamic acid, 2-chlorobenzohydroxamic acid, 2-fluorobenzohydroxamic acid, 2-nitrobenzohydroxamic acid, 3-nitrobenzohydroxamic acid, 4-aminobenzohydroxamic acid, 4-chlorobenzohydroxamic acid, 4-fluorobenzohydroxamic acid, 4-nitrobenzohydroxamic acid and their salts.

The aminocarboxylic acids expressly mentioned are glutamic acid, beta-hydroxyglutamic acid, aspartic acid, asparagine, azaserine, cysteine, histidine, 3-methylhistidine, cytosine, 7-aminocephalosporanic acid and carnosine.

The cyclic monocarboxylic acids expressly mentioned are naphthalene -2-carboxylic acid, cyclohexane carboxylic acid, cyclohexyl acetic acid, 2-phenyllactic acid, 4-hydroxybenzoic acid, 3-hydroxybenzoic acid, 2-pyridinecarboxylic acid, cis- and trans-, cyclohexane carboxylic acid, benzoic acid eyes and salts thereof.

The unsaturated monocarboxylic acids expressly mentioned are cinnamic acid, acrylic acid, 3-chloroprop-2-enecarboxylic acid, crotonic acid , 4-but-2-enecarboxylic acid, cis- or trans-2-pentanoic acid, 2-methyl-2-pentanoic acid, 2-hexenoic acid and 3-ethyl-2-hexenoic acid and their salts.

The phenols expressly mentioned are nitrophenol, 2,6-dihalo-4-nitrophenols, 2,6-di-C₁₋₁₂-alkyl-4-nitrophenols, 2,4-dinitrophenol, 3,4-dinitrophenol, 2-C₁-₁₂-alkyl-4,6-dinitrophenols, 2-halo-4,6-dinitrophenols, dinitro-o-cresol, picric acid and salts thereof.

The sulfonamides expressly mentioned are N-chlorotolylsulfonamide, dichlorophenamide mafenide, nimesulide, sulfamethizole, sulfaperin, sulfacetamide, sulfadiazine, sulfadimethoxine, sulfamethazine, sulfapyridine, sulfaquinoxaline and their salts.

The thiols expressly mentioned are hydrogen disulfide, cysteamine, cysteinylcysteine, methyl cysteine, thiophenol, p-chloro thiophenol, o-aminothiolphenol, o-mercaptophenyl acetic acid p-nitrobenzenethiol, 2-mercaptoethanesulfonate, N-dimethylcysteamine, dipropylcysteamine, diethylcysteamine, mercaptoethylmorpholine, methylthioglycolate, mercaptoethylamine, N-trimethylcysteine, glutathione, mercaptoethylpiperidine, diethylaminopropanethiol and their salts.

The polishing additives are believed to increase the oxide-to-nitride selectivity.

The American patent application US 2006/0124594 A1 discloses a ceria-based CMP slurry having a viscosity of at least 1.5 cP and comprising a viscosity increasing agent including a nonionic polymer such as polyethylene glycol (PEG). The ceria-based CMP slurry is said to have a high oxide-to-nitride selectivity and a low within-wafer non-uniformity WIWNU.

The American patent application US 2006/0207188 A1 discloses a ceria-based CMP slurry containing the reaction product of a polymer such as polyacrylic acid or poly(alkyl methacrylate) and a monomer such as acrylamide, methacrylamide, ethyl-methacrylamide, vinylpyridine, or vinylpyrrolidone. The reaction products are believed to increase also the oxide-to-nitride selectivity.

The American patent application US 2006/0216935 A1 discloses a ceria-based CMP slurry comprising protein, lysine and/or arginine and a pyrrolidone compounds such as polyvinylpyrrolidone (PVP), N-octyl-2-pyrrolidone, N-ethyl-2-pyrrolidone, N-hydroxyethyl-2-pyrrolidone, N-cyclohexyl-2-pyrrolidone, N-butyl-2-pyrrolidone, N-hexyl-2-pyrrolidone, N-decyl-2-pyrrolidone, N-octadecyl-2-pyrrolidone, and N-hexadecyl-2-pyrrolidone. The ceria-based CMP slurry can furthermore contain dispersing agents like polyacrylic acid, glycols and polyglycols. Specific examples use proline, polyvinylpyrrolidone or N-octyl-2-pyrrolidone, PPO/PEO blockcopolymers, and glutaraldehyde. The ceria-based CMP slurry is believed to not aggressively remove trench silicon dioxide thereby allowing for extended polishing beyond the endpoint without substantially increasing the minimum step height.

The American patent application US 2007/0077865 A1 discloses a ceria-based CMP slurry containing polyethyleneoxides/polypropyleneoxide copolymers preferably from the Pluronic™ family sold by BASF. The ceria-based CMP slurry can furthermore contain amino alcohols such as 2-dimethylamino-2-methyl-1-propanol (DMAMP), 2-amino-2-ethyl-1-propanol (AMP), 2-(2-aminoethylamino)ethanol, 2-(isopropylamino)ethanol, 2-(methylamino)ethanol, 2-(diethylamino)ethanol, 2-(2-dimethylamino)ethoxy)ethanol, 1,1'-[[3-(dimethylamino)propyl]imino]-bis-2-propanol, 2-(2-butylamino)ethanol, 2-(tert-butylamino)ethanol, 2-(diisopropylamino)ethanol, and N-(3-aminopropyl)morpholine. The ceria-based CMP slurry may furthermore contain quaternary ammonium compounds like tetramethylammonium hydroxide, film forming agents such as alkyl amines, alkanolamines, hydroxyl amines, phosphate esters, sodium lauryl sulfate, fatty acids, polyacrylates, polymethacrylates, polyvinylphosphonates, polymalates, polystyrene sulfonate, polyvinyl sulfate, benzotriazole, triazole, and benzoimidazole, and complexing agents such as acetylacetone, acetates, glycolates, lactates, gluconates, gallic acid, oxalates, phthalates, citrates, succinates, tartates, malates, ethylenediaminetetraacetic acid, ethylene glycol, pyrocatechol, pyrogallol, tannic acid, phosphonium salts and phosphonic acids. The ceria-based CMP slurry is believed to provide good selectivity of silicon oxide and/or silicon nitride relative to polysilicon.

The American patent application US 2007/0175104 A1 discloses a ceria-based CMP slurry comprising a polysilicon polishing inhibitor which is selected from water-soluble polymers having a N-monosubstituted or N,N-di-substituted skeleton substituted by any members selected from the group consisting of acrylamide, methacrylamide and alpha-substituted derivatives thereof; polyethylene glycols; polyvinylpyrrolidones; alkyloxylated linear aliphatic alcohols and ethyleneoxide adducts of acetylene-based diols. The ceria-based CMP slurry may contain additional water-soluble polymers such as polysaccharides like alginic acid, pectin acid, carboxymethylcellulose, agar, curdlan, and pullulan; polycarboxylic acids such as polyaspartic acid, polyglutamic acid, polylysine, polymalic acid, polymethacrylic acid, polyimide acid, polymaleic acid, polyitaconic acid, polyfumaric acid, poly(p-styrene carboxylic acid), polyacrylic acid, polyacrylamide, amino polyacrylamide, polyglyoxalic acid and their salts; and vinyl polymers such as polyvinyl alcohol, and polyacrolein. The ceria-based CMP slurry is said to have a high silicon oxide over polysilicon selectivity.

The American patent application US 2007/0191244 A1 discloses a ceria-based CMP slurry containing a compound having a weight-average molecular weight of 30 to 500 and containing hydroxyl groups and a carboxyl group or both such as citrates, malates, gluconates, tartrates, 2-hydroxyisobutyrates, adipates, octanoates, succinates, EDTA-containing compounds, glutarates, methylenesuccinates, mannose, glycero-galacto-heptose, erythro-manno-octose, arabino-galacto-nonose, and glutamine. The ceria-based CMP slurry may furthermore contain linear polymer acids or graft type polymer acids having alkoxypolyalkylene glycol side chains. The ceria-based CMP slurry is said to achieve an improved global planarity of the polished wafers.

The American patent application US 2007/0218811 A1 discloses a ceria-based CMP slurry having a pH of 4 to 7.5 and containing a dispersing agent, a polycarboxylic acid, and 100 to 1000 ppm of a strong acid having a pKa of its first dissociable acidic group at 3.2 or less. By way of examples, polymers of acrylic acid and methacrylic acid are mentioned as anionic dispersing agents, polyoxyethylene derivatives are mentioned as nonionic dispersing agents, and polyvinylpyrrolidone is mentioned as a cationic dispersing agent. Specifically mentioned strong acids are sulfuric acid, HCI, nitric acid, phosphoric acid, oxalic acid, maleic acid, picric acid, sulfurous acid, thiosulfurous acid, amidosulfuric acid, chloric acid, perchloric acid, chlorous acid, hydroiodic acid, periodic acid, iodic acid, hydrobromic acid, perbromic acid, chromic acid, nitrous acid, diphosphonic acid, tripolyphosphoric acid, phosphinic acid, picolinic acid, phosphonic acid, isonicotinic acid, nicotinic acid, trichloroacetic acid, dichloroacetic acid, chloroacetic acid, cyanoacetic acid, oxaloacetic acid, nitroacetic acid, bromoacetic acid, fluoroacetic acid, phenoxyacetic acid, o-bromobenzoic acid, o-nitrobenzoic acid, o-chlorobenzoic acid, p-aminobenzoic acid, anthranilic acid, phthalic acid, fumaric acid, malonic acid, tartaric acid, citric acid, o-chloroaniline, 2,2'-bipyridine, 4,4'-bipyridine, 2,6-pyridinedicarboxylic acid, pyruvic acid, polystyrene sulfonic acid, polysulfonic acid, glutamic acid, salicylic acid, aspartic acid, 2-aminoethylphosphonic acid, lysine, arginine, isoleucine, sarcosine, ornithine, guanosine, citrulline, tyrosine, valine, hypoxanthine, methionine, lysine, and leucine. The ceria-based CMP slurry is said to cause an efficient high-speed operation, an easier process management and a smaller fluctuation in film thickness due to difference in pattern density.

The American patent applications US 2008/0085602 A1 and US 2008/0124913 A1 disclose a ceria-based CMP slurry containing 0.001 to 0.1% by weight of the nonionic surfactant selected from ethyleneoxide-propyleneoxide-ethyleneoxide triblock copolymers and polyacrylic acid as dispersing agent. The ceria-based slurry he said to have a high silicon oxide and silicon nitride over polysilicon selectivity.

The fabrication of electrical devices, in particular, semiconductor integrated circuits (ICs); requires high precision methods which involve inter alia high selectivity CMP.

Although the prior art ceria-based CMP slurries may have a satisfactory oxide-to-polysilicon selectivity and may yield polished wafers having a good global and local planarity as exemplified by the within-wafer nonuniformity (WIWNU) and the wafer-to-wafer nonuniformity (WTWNU), the ever decreasing dimensions of the IC architectures, in particular ICs with LSI (large-scale integration) or VLSI (very-large-scale integration), necessitate the constant improvement of the ceria-based CMP slurries in order to and meet the ever increasing technical and economical demands of the manufacturers of integrated circuit devices.

However, this pressing need to constantly improve the prior art ceria-based CMP slurries does not only apply to the field of integrated circuit devices, but the polishing and planarization efficacy has also to be improved in the fields of manufacturing other electrical devices such as liquid crystal panels, organic electroluminescent panels, printed circuit boards, micro machines, DNA chips, micro plants, photovoltaic cells, and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks. The manufacturing of such electrical and optical devices also requires high precision CMP process steps.

The European patent application EP 1 338 636 A1 discloses a ceria-based CMP slurry comprising an anti-solidification agent selected from a group consisting of cellulose, crystalline cellulose, cellulose derivatives, silica, alginates, beta-naphthalene sulfonate formalin condensates, calcium secondary phosphate, proteins, polypeptides and organic high-molecular flocculants, and a dispersing agent or surfactant such as a condensed phosphate like pyrophosphoric acid, sodium pyrophosphate, sodium tripolyphosphate or sodium hexametaphosphate. However, only the polishing of glass is disclosed

The Japanese patent application JP 2005-336400 A discloses a ceria-based CMP slurry comprising a water-soluble condensed phosphate such as pyrophosphate, tripolyphosphate and hexametaphosphoric acid salt, and a water-soluble carbonate or hydrogencarbonate. The ceria-based CMP slurry may furthermore contain a water-soluble organic solvent such as methanol, ethanol, 1-propanol, 2-propanol, 1-butanol, 2-butanol, ethylene glycol, propylene glycol and 1,2,3-propanetriol, ketones such as acetone and methylethylketone, tetrahydrofurane, N,N-dimethylformamide, dimethyl sulfoxide, and 1,4-dioxane. The ceria-based CMP slurry is said to have improved polishing with regard to polishing accuracy, cleaning, initial polishing speed and polishing speed. However, only the polishing of glass is disclosed.

The Japanese patent application JP 2001-240850 A discloses a CMP slurry containing a alumina, zirconia or silicon carbide as the abrasive, an alkylene oxide-ethyleneoxide block or random copolymer as dispersing agent and sodium phosphate or sodium polyphosphate as an "anti-rust". The CMP slurry is used for polishing silicon wafers, glass, aluminum, ceramic, synthetic silica, quartz and sapphire.

EP 1 747 849 A1 discloses a composition for polishing, comprising: a component (A), which is a water-soluble organic compound containing a carboxyl group or a salt thereof; and a component (B), which is an aqueous sol of cerium oxide particles obtained by calcining a cerium compound by holding it in at least two different calcining temperature ranges and wet-milling the resultant cerium oxide powder until the ratio of the mean particle size (b1) measured in the aqueous sol by the laser diffraction method to the particle size (b2) as determined from the specific surface area measured by the gas adsorption method is in the range of either 1 to 4 or 15 to 40, wherein the mean particle size measured in the composition for polishing by the laser diffraction method is 50 to 150 nm.

EP 2 131 389 A1 discloses a chemical mechanical polishing aqueous dispersion including (A) colloidal silica having an average particle size calculated from the specific surface area determined by the BET method of 10 to 60 nm, (B) an organic acid having two or more carboxyl groups and one or more hydroxyl groups in one molecule, and (C) a quaternary ammonium compound, wherein the chemical mechanical polishing aqueous dispersion has a pH of 3 to 5.

US 6 270 393 B1 discloses an abrasive slurry containing an alumina grain, an inorganic salt, a water-soluble chelating agent, an abrasive oil and a hardly water-soluble chelate aluminum salt or chelate nickel salt. The alumina grain has an average particle diameter of from 0.05 to 1 µm in an amount of from 0.1 to 10 percent by weight. The abrasive slurry is used for abrading an insulation layer of a semiconductor integrated circuit and a magnetic thin film head while they are produced.

US 2009/035202 A1 discloses a method for producing a cerium oxide-based abrasive ensuring high removal rate, less generation of scratches and high precision polished surface with small surface roughness.

### Objects of the Invention

Therefore, it is an object of the present invention to provide a novel aqueous polishing composition, in particular a novel chemical mechanical polishing (CMP) composition, especially a novel ceria-based CMP slurry, which no longer exhibits the disadvantages and drawbacks of the prior art polishing compositions.

In particular, the novel aqueous polishing composition, in particular the novel chemical mechanical polishing (CMP) composition, especially the novel ceria-based CMP slurry, should exhibit a significantly improved oxide-to-polysilicon selectivity and yield polished wafers having an excellent global and local planarity as exemplified by the within-wafer nonuniformity (WIWNU) and the wafer-to-wafer nonuniformity (WTWNU). Therefore, they should be excellently suited for manufacturing IC architectures, in particular ICs with LSI (large-scale integration) or VLSI (very-large-scale integration), having structures with dimensions below 50 nm.

Moreover, the novel aqueous polishing composition, in particular the novel chemical mechanical polishing (CMP) composition and especially the novel ceria-based CMP slurry should not only be exceptionally useful in the field of integrated circuit devices, but should also be most efficiently and advantageously useful in the fields of manufacturing other electrical devices such as liquid crystal panels, organic electroluminescent panels, printed circuit boards, micro machines, DNA chips, micro plants and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

Most particularly, the novel ceria-based CMP slurries should also exhibit a high nitride-to-polysilicon selectivity and a moderate oxide-to-nitride selectivity.

It is a further object of the present invention to provide a novel process for polishing substrates for mechanical, electrical and optical devices, the said substrate materials containing silicon oxide dielectric and polysilicon films, optionally containing silicon nitride films.

### Summary of the Invention

Accordingly, the novel aqueous polishing composition has been found, the said aqueous polishing composition comprising
(A) at least one type of abrasive particles consisting of ceria which are positively charged when dispersed in an aqueous medium which is free from component (C) and has a pH in the range of from 3 to 9 as evidenced by the electrophoretic mobility; wherein the abrasive particles consisting of ceria may contain minor amounts of other rare earth metal oxides
(B) at least one water-soluble or water-dispersible polymer selected from the group consisting of linear and branched alkylene oxide homopolymers and copolymers; and
(C) at least one anionic phosphate dispersing agent,
wherein the composition contains the water-soluble polymer (B) in amounts of from 0.001 to 5% by weight.

Hereinafter, the novel aqueous polishing composition is referred to as the "composition of the invention".

Moreover, the novel process for polishing substrates for mechanical, electrical and optical devices by contacting the substrate material at least once with the composition of the invention and polishing the substrate material until the desired planarity is achieved, has been found

Hereinafter, the novel process for polishing substrate materials for mechanical, electrical and optical devices is referred to as the "process of the invention".

### Advantages of the Invention

In view of the prior art, it was surprising and could not be expected by the skilled artisan that the objects of the present invention could be solved by the composition of the invention and the process of the invention.

It was particularly surprising that the composition of the invention exhibited a significantly improved oxide-to-polysilicon selectivity and yield polished wafers having an excellent global and local planarity as exemplified by the within-wafer nonuniformity (WIWNU) and the wafer-to-wafer nonuniformity (WTWNU). Therefore, they were excellently suited for manufacturing IC architectures, in particular ICs with LSI (large-scale integration) or VLSI (very-large-scale integration), having structures with dimensions below 50 nm.

Additionally, the composition of the invention was stable during prolonged transport and storage, which stability significantly improved the logistics and the process management.

Moreover, the composition of the invention was not only exceptionally useful in the field of integrated circuit devices, but was also most efficiently and advantageously useful in the fields of manufacturing other electrical devices such as liquid crystal panels, organic electroluminescent panels, printed circuit boards, micro machines, DNA chips, micro plants and magnetic heads; as well as high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

Most particularly, the composition of the invention also exhibited a high nitride-to-polysilicon selectivity coupled with a moderate oxide-to-nitride selectivity.

Therefore, the composition of the invention was most particularly useful for the process of the invention. The process of invention could be most advantageously used for polishing, in particular chemically mechanically polishing, substrate materials for electrical devices such as liquid crystal panels, organic electroluminescent panels, printed circuit boards, micro machines, DNA chips, micro plants and magnetic heads; as well as substrate materials for high precision mechanical devices and optical devices, in particular, optical glasses such as photo-masks, lenses and prisms, inorganic electro-conductive films such as indium tin oxide (ITO), optical integrated circuits, optical switching elements, optical waveguides, optical monocrystals such as the end faces of optical fibers and scintillators, solid laser monocrystals, sapphire substrates for blue laser LEDs, semiconductor monocrystals, and glass substrates for magnetic disks.

Most particularly however, the process of the invention was excellently suited for polishing semiconductor wafers containing silicon oxide dielectric and polysilicon films and optionally containing silicon nitride films. The process of the invention yielded polished wafers having an excellent global and local planarity and balance without dishing, cupping or hotspots as exemplified by the within-wafer nonuniformity (WIWNU) and the wafer-to-wafer nonuniformity (WTWNU). Therefore, they were excellently suited for manufacturing IC architectures, in particular ICs with LSI (large-scale integration) or VLSI (very-large-scale integration), having structures with dimensions below 50 nm.

### Detailed Description of the Invention

The composition of the invention is an aqueous composition. This means that it contains water, in particular ultrapure water, as the main solvent and dispersing agent. Nevertheless, the composition of the invention may contain at least one water-miscible organic solvent, however, only in minor amounts that do not change the aqueous nature of the composition of the invention.

Preferably, the composition of the invention contains water in amounts of from 60 to 99.95% by weight, more preferably 70 to 99.9% by weight, even more preferably 80 to 99.9% by weight and, most preferably, 90 to 99.9% by weight, the weight percentages being based on the complete weight of the composition of the invention.

"Water-soluble" means that the relevant component or ingredient of the composition of the invention can be dissolved in the aqueous phase on the molecular level.

"Water-dispersible" means that the relevant component or ingredient of the composition of the invention can be dispersed in the aqueous phase and forms a stable emulsion or suspension.

The first essential ingredient of the composition of the invention is at least one, preferably one, type of abrasive particles (A).

The abrasive particles (A) are positively charged when the dispersed in an aqueous medium which is free from the anionic phosphate dispersing agent (C) hereinafter described and has a pH in the range of from 3 to 9. The positive charge is evidenced by the electrophoretic mobility µ (µm/s) (V/cm) of the abrasive particles (A). The electrophoretic mobility µ can be directly measured with instruments such as Zetasizer Nano from Malvern, Ltd.

The average particle size of the abrasive particles (A) can vary broadly and, therefore, can be adjusted most advantageously to the particular requirements of a given composition and process of the invention. Preferably, the average particle size as determined by dynamic laser light scattering is in the range of from 1 to 2000 nm, preferably 1 to 1000 nm, more preferably 1 to 750, and, most preferably, 1 to 500 nm.

The particle size distribution of the abrasive particles (A) can be monomodal, bimodal or multimodal. Preferably, the particle size distribution is monomodal in order to have an easily reproducible property profile of the abrasive particles (A) and easily reproducible conditions during the process of the invention.

Moreover, the particle size distribution of the abrasive particles (A) can be narrow or broad. Preferably, the particle size distribution is narrow with only small amounts of small particles and large particles in order to have an easily reproducible property profile of the abrasive particles (A) and easily reproducible conditions during the process of the invention.

The abrasive particles (A) can have various shapes. Thus, they may be of one or essentially one type of shape. However, it also possible that the abrasive particles (A) have different shapes. In particular, two types of differently shaped abrasive particles (A) may be present in a given composition of the invention. As regards the shapes themselves, they can be cubes, cubes with chamfered edges, octahedrons, icosahedrons, nodules and spheres with or without protrusions or indentations. Most preferably, the shape is spherical with no or only very few protrusions or indentations. This shape, as a rule, is preferred because it usually increase is the resistance to the mechanical forces the abrasive particles (A) are exposed to it during a CMP process.

Inorganic abrasive particles (A) consisting of ceria are used.

The abrasive particles (A) which contain ceria can contain minor amounts of other rare earth metal oxides.

The amount of the abrasive particles (A) used in the composition of the invention can vary broadly and, therefore, can be adjusted most advantageously to the particular requirements of a given composition and process of the invention. Preferably, the composition of the invention contains 0.005 to 10% by weight, more preferably 0.01 to 8% by weight and, most preferably 0.01 to 6% by weight of the abrasive particles (A), the weight percentages being based on the complete weight of the composition of the invention.

The second essential ingredient of the composition of the invention is at least one, preferably one, water-soluble polymer (B) selected from the group consisting of linear and branched alkylene oxide, preferably ethyleneoxide and propyleneoxide, homopolymers and copolymers.

The preferred ethyleneoxide-propyleneoxide copolymers (B) can be random copolymers, alternating copolymers or blockcopolymers containing polyethyleneoxide blocks and polypropyleneoxide blocks.

Preferably, in the ethyleneoxide-propyleneoxide blockcopolymers, the polyethyleneoxide blocks have hydrophile-lipophile-balance (HLB) values from 10 to 15. The polypropyleneoxide blocks may have a HLB values of from 28 to about 32.

The water-soluble polymers (B) are customary and known, commercially available materials. Suitable water-soluble polymers (B) are described in the Japanese patent application JP 2001-240850 A, claim 2 in conjunction with the paragraphs [0007] to [0014], the American patent application US 2007/0077865 A1, column page 1, paragraph [0008] to page 2, paragraph [0010], the American patent application US 2006/0124594 A1, page 3, paragraphs [0036] and [0037] and the American patent application US 2008/0124913 A1, page 3, paragraphs [0031] to [0033] in conjunction with the claim 14 or they are sold under the trademarks Pluronic™, Tetronic™ and Basensol™ by BASF Corporation and BASF SE as evidenced by the company brochure of BASF Corporation "Pluronic™ & Tetronic™ Block Copolymer Surfactants, 1996" or the American patent US 2006/0213780 A1.

Most preferably, polyethylene glycol (PEG) is used.

The concentration of the water-soluble polymer (B) and the composition of the invention can vary broadly and, therefore, can be adjusted most advantageously to the particular requirements of a given composition and process of the invention. The composition of the invention contains the water-soluble polymer (B) in amounts of from 0.001 to 5% by weight, more preferably 0.005 to 2.5% by weight, even more preferably 0.0075 to 1% by weight and, most preferably, 0.0075 to 0.5% by weight.

The composition of the invention contains at least one, preferably one, anionic phosphate dispersing agent (C).

Preferably, the anionic phosphate dispersing agent (C) is selected from the group consisting of water-soluble condensed phosphates.

Examples for water-soluble condensed phosphates (C) are salts, in particular ammonium, sodium and potassium salts, of metaphosphates of the general formula I:

[M+ₙ(PO₃)n] (I);

and polyphosphates of the general formula II and III:

M⁺ₙPₙO₃ₙ₊₁ (II);

M⁺H₂PnO₃ₙ+₁ (III);

wherein M is ammonium, sodium and potassium and the index n is from 2 to 10,000. Regarding the polyphosphates of formulas I, II, and III, the index n is preferably from 2 to 2,000, more preferably from 2 to 300, most preferably from 2 to 50, particularly from 2 to 15, for example from 3 to 8.

Examples for particularly suitable water-soluble condensed phosphates (C) are Graham's salt (NaPO₃)₄₀-₅₀, Calgon™(NaPO₃)₁₅₋₂₀, Kurrol's salt (NaPO₃)ₙ with n = about 5000, and ammonium, sodium and potassium hexametaphosphate.

The concentration of the water-soluble anionic phosphate dispersing agent (C) in the composition of the invention can vary broadly and, therefore, can be adjusted most advantageously to the particular requirements of a given composition and process of the invention. Preferably, the anionic phosphate dispersing agents (C) is used in amounts so that a weight ratio of ceria to anionic phosphate dispersing agent (C) of 10 to 2000 and, more preferably, 20 to 1000 results.

The composition of the invention can contain optionally at least one functional component (D) which is different from the ingredients or components (A), (B) and (C).

Preferably, the functional component (D) is selected from the group of compounds customarily used in ceria-based CMP slurries. Examples of such compounds (D) are described at the outset and are disclosed, for example, by Y. N. Prasad et al. in Electrochemical and Solid-State Letters, 9 (12) G337-G339 (2006), Hyun-Goo Kang et al. in Journal of Material Research, volume 22, No. 3, 2007, pages 777 to 787, S. Kim et al. in Journal of Colloid and Interface Science, 319 (2008), pages 48 to 52, S. V. Babu et al. in Electrochemical and Solid-State Letters, 7 (12) G327-G330 (2004), Jae-Dong Lee et al. in Journal of the Electrochemical Society, 149 (8) G477-G481, 2002, the American patents US 5,738,800, US 6, 042, 741, US 6,132,637, US 6,218,305 B, US 5,759,917, US 6,689,692 B1, US 6,984,588 B2, US 6,299,659 B1, US 6,626,968 B2, US 6,436,835, B1 US 6,491,843 B1, US 6,544,892 B2, US 6,627,107 B2, US 6,616,514 B1, and US 7,071,105 B2, the American patent applications US 2002/0034875 A1, US 2006/0144824 A1, US 2006/0207188 A1, US 2006/0216935 A1, US 2007/0077865 A1, US 2007/0175104 A1, US 2007/0191244 A1 and US 2007/0218811 A1, and the Japanese patent application JP 2005-336400 A.

Moreover, the functional component (D) is selected from the group consisting of organic, inorganic and hybrid organic-inorganic abrasive particles being different from the particles (D), materials having a lower critical solution temperature LCST or an upper critical solution temperature UCST, oxidizing agents, passivating agents, charge reversal agents, organic polyols having at least 3 hydroxide groups that are not dissociable in the aqueous medium, oligomers and polymers formed from at least one monomer having at least 3 hydroxide groups that are not dissociable in the aqueous medium, complexing or chelating agents, frictive agents, stabilizing agents, rheology agents, surfactants, metal cations and organic solvents.

Suitable organic abrasive particles (D) and their effective amounts are known, for example, from the American patent application US 2008/0254628 A1, page 4, paragraph [0054] or from the international application WO 2005/014753 A1, wherein solid particles consisting of melamine and melamine derivatives such as acetoguanamine, benzoguanamine and dicyandiamide are disclosed.

Suitable inorganic abrasive particles (D) and their effective amounts are known, for example, from the international patent application WO 2005/014753 A1, page 12, lines 1 to 8 or the American patent US 6,068,787, column 6, line 41 to column 7, line 65.

Suitable hybrid organic-inorganic abrasive particles (D) and their effective amounts are known, for example, from the American patent applications US 2008/0254628 A1, page 4, paragraph [0054] or US 2009/0013609 A1, page 3, paragraph [0047] to page 6, paragraph [0087].

Suitable oxidizing agents (D) and their effective amounts are known, for example, from the European patent application EP 1 036 836 A1, page 8, paragraphs [0074] and [0075] or from the American patents US 6,068,787, column 4, line 40 to column 7, line 45 or US 7,300,601 B2, column 4, lines 18 to 34. Preferably, organic and inorganic peroxides, more preferably inorganic peroxides, are used. In particular, hydrogen peroxide is used.

Suitable passivating agents (D) and their effective amounts are known, for example, from the American patent US 7,300,601 B2, column 3, line 59 to column 4, line 9 or from the American patent application US 2008/0254628 A1, the paragraph [0058] bridging the pages 4 and 5.

Suitable complexing or chelating agents (D), which are sometimes also designated as frictive agents (cf. the American patent application US 2008/0254628 A1, page 5, paragraph [0061]) or etching agents or etchants (cf. the American patent application US 2008/0254628 A1, page 4, paragrap [0054]), and their effective amounts are known, for example, from the American patent US 7,300,601 B2, column 4, lines with 35 to 48. The amino acids, in particular glycine, and, moreover, dicyandiamide and triazines containing at least one, preferably two and, more preferably, three primary amino groups such as melamine and water-soluble guanamines, particularly melamine, formoguanamine, acetoguanamine and 2,4-diamino-6-ethyl-1,3,5-triazine, are most particularly preferably used.

Suitable stabilizing agents (D) and their effective amounts are known, for example, from the American patent US 6,068,787, column 8, lines 4 to 56.

Suitable rheology agents (D) and their effective amounts are known, for example, from the American patent application US 2008/0254628 A1, page 5, paragraph [0065] to page 6, paragraph [0069].

Suitable surfactants (D) and their effective amounts are known, for example, from the international patent application WO 2005/014753 A1, page 8, line 23, to page 10, line 17 or from the American patent US 7,300,601 B2, column 5, line 4 to column 6, line 8.

Suitable polyvalent metal ions (D) and their effective amounts are known, for example, from the European patent application EP 1 036 836 A1, page 8, paragraph [0076] to page 9, paragraph [0078].

Suitable organic solvents (D) and their effective amounts are known, for example, from the American patent US 7,361,603 B2, column 7, lines 32 to 48 or the American patent application US 2008/0254628 A1, page 5, paragraph [0059].

Suitable materials (D) exhibiting a lower critical solution temperature LCST or an upper critical solution temperature UCST are described, for example, in the article of H. Mori, H. Iwaya, A. Nagai and T. Endo, Controlled synthesis of thermoresponsive polymers derived from L-proline via RAFT polymerization, in Chemical Communication, 2005, 4872-4874; or in the article of D. Schmaljohann, Thermo- and pH-responsive polymers and drug delivery, Advanced Drug Delivery Reviews, volume 58 (2006), 1655-1670 or in the American patent applications US 2002/0198328 A1, US 2004/0209095 A1, US 2004/0217009 A1, US 2006/0141254 A1, US 2007/0029198 A1, US 2007/0289875 A1, US 2008/0249210 A1, US 2008/0050435 A1 or US 2009/0013609 A1, the American patents US 5,057,560, US 5,788,82 and US6,682,642 B2, the international patent applications WO 01/60926 A1, WO2004/029160 A1, WO 2004/0521946 A1, WO 2006/093242 A2 or WO 2007/012763 A1, in the European patent applications EP 0 583 814 A1, EP 1 197 587 B1 and EP 1 942 179 A1, or the German patent application DE 26 10 705.

In principle, any known charge reversal agent (D) customarily used in the field of CMP can be used. Preferably, the charge reversal agent (D) is selected from the group consisting of monomeric, oligomeric and polymeric compounds containing at least one anionic group selected from the group consisting of carboxylate, sulfinate, sulfate and phosphonate groups.

If present, the functional component (D) can be contained in varying amounts. Preferably, the total amount of (D) is not more than 10 wt.% ("wt.%" means "percent by weight"), more preferably not more than 2 wt.%, most preferably not more than 0.5 wt.%, particularly not more than 0.1 wt.%, for example not more than 0.01 wt.%, based on the total weight of the corresponding CMP composition. Preferably, the total amount of (D) is at least 0.0001 wt.%, more preferably at least 0.001 wt.%, most preferably at least 0.008 wt.%, particularly at least 0.05 wt.%, for example at least 0.3 wt.%, based on the total weight of the corresponding composition.

The composition of the invention can optionally contain at least one pH-adjusting agent or buffering agent (E) which is materially different from the ingredients (A), (B) and (C).

Suitable pH-adjusting agents or buffering agents (E) and their effective amounts are known, for example, from the European patent application EP 1 036 836 A1, page 8, paragraphs [0080], [0085] and [0086], the international patent application WO 2005/014753 A1, page 12, lines 19 to 24, the American patent application US 2008/0254628 A1, page 6, paragraph [0073] or the American patent US 7,300,601 B2, column 5, lines 33 to 63. Examples for pH-adjusting agents or buffering agents (E) are potassium hydroxide, ammonium hydroxide, tetramethylammonium hydroxide (TMAH), nitric acid, and sulfuric acid.

If present, the pH-adjusting agent or buffering agent (E) can be contained in varying amounts. Preferably, the total amount of (E) is not more than 20 wt.%, more preferably not more than 7 wt.%, most preferably not more than 2 wt.%, particularly not more than 0.5 wt.%, for example not more than 0.1 wt.%, based on the total weight of the corresponding CMP composition. Preferably, the total amount of (E) is at least 0.001 wt.%, more preferably at least 0.01 wt.%, most preferably at least 0.05 wt.%, particularly at least 0.1 wt.%, for example at least 0.5 wt.%, based on the total weight of the corresponding composition.

Preferably, the pH of the composition of the invention is set between 3 and 10, more preferably, 3 and 8, even more preferably between 3 and 7, and, most preferably between 5 and 7 preferably using the aforementioned pH-adjusting agents (E).

The preparation of the composition of the invention does not exhibit any particularities but can be carried out by dissolving or dispersing the above-described ingredients (A), (B) and (C) and optionally (D) and/or (E) in an aqueous medium, in particular, de-ionized water. For this purpose, the customary and standard mixing processes and mixing apparatuses such as agitated vessels, in-line dissolvers, high shear impellers, ultrasonic mixers, homogenizer nozzles or counterflow mixers, can be used. Preferably, the composition of the invention thus obtained can be filtered through filters of the appropriate mesh aperture, in order to remove coarse-grained particles such as the agglomerates or aggregates of the solid, finely dispersed abrasive particles (A).

The compositions of the invention are excellently suited for the process of the invention.

In the process of the invention, a substrate material for electrical, mechanical and optical devices, in particular, electrical devices, most preferably, integrated circuit devices, is contacted at least once with a composition of the invention and polished, in particular, chemically and mechanically polished, until the desired planarity is achieved.

The process on the invention exhibits its particular advantages in the CMP of silicon semiconductor wafers having isolating layers consisting of low-k or ultra-low-k silicon oxide materials and polysilicon layers, optionally containing silicon nitride layers.

Suitable low-k or ultra-low-k materials and suitable methods of preparing the insulating dielectric layers are described in, for example, the American patent applications US 2005/0176259 A1, page 2, paragraphs [0025] to [0027], US 2005/0014667 A1, page 1, paragraph [0003], US 2005/0266683 A1, page 1, paragraph [0003] and page 2, paragraph [0024] or US 2008/0280452 A1, paragraphs [0024] to [0026] or in the American patent US 7,250,391 B2, column 1, lines 49 to 54 or in the European patent application EP 1 306 415 A2, page 4, paragraph [0031].

The process of the invention is particularly suited for the shallow trench isolation (STI) which requires the selective removal of silicon dioxide over polysilicon on a patterned wafer substrate. In this process, etched trenches are overfilled with the dielectric material, e.g., silicon dioxide, which is polished using the silicon nitride barrier film as the stopping layer. In this preferred embodiment, the process of the invention ends with clearing the silicon dioxide from the barrier film while minimizing the removal of exposed polysilicon and trench silicon oxide.

Moreover, the process of the invention is also particularly well-suited for the shallow trench isolation (STI) wherein a silicon nitride layer is also present, because the composition of the invention exhibits a high oxide-to-polysilicon selectivity in conjunction with a moderate oxide-to-nitride selectivity.

Thus, the process of the invention exhibits an oxide-to-polysilicon selectivity greater than 50, preferably greater than 75 and most preferably greater than 100 and a nitride-to-polysilicon selectivity greater than 10, preferably greater than 20, and most preferably greater than 25.

The oxide-to nitride-selectivity is preferably in the range of 3 to 10, more preferably in the range of 3 to 6.

The nitride-to-polysilicon selectivity is preferably >10.

The process of the invention exhibits no particularities but can be carried out with the processes and the equipment customarily used for the CMP in the fabrication of semiconductor wafers with ICs.

As is known in the art, a typical equipment for the CMP consists of a rotating platen which is covered with a polishing pad. The wafer is mounted on a carrier or chuck with its upper side down facing the polishing pad. The carrier secures the wafer in the horizontal position. This particular arrangement of polishing and holding device is also known as the hard-platen design. The carrier may retain a carrier pad which lies between the retaining surface of the carrier and the surface of the wafer which is not being polished. This pad can operate as a cushion for the wafer.

Below the carrier, the larger diameter platen is also generally horizontally positioned and presents a surface parallel to that of the wafer to be polished. Its polishing pad contacts the wafer surface during the planarization process. During the CMP process of the invention, the composition of the invention is applied onto the polishing pad as a continuous stream or in dropwise fashion.

Both the carrier and the platen are caused to rotate around their respective shafts extending perpendicular from the carrier and the platen. The rotating carrier shaft may remain fixed in position relative to the rotating platen or may oscillate horizontally relative to the platen. The direction of rotation of the carrier typically, though not necessarily, is the same as that of the platen. The speeds of rotation for the carrier and the platen are generally, though not necessarily, set at different values.

Customarily, the temperature of the platen is set at temperatures between 10 and 70°C.

For further details reference is made to the international patent application WO 2004/063301 A1, in particular page 16, paragraph [0036] to page 18, paragraph [0040] in conjunction with the figure 1.

By way of the process of the invention semiconductor wafers with ICs comprising patterned polysilicon and low-k and ultra-low-k material layers, in particular silicon dioxide layers, having an excellent planarity can be obtained. Therefore, copper damascene patterns can be obtained which also have an excellent planarity and, in the finished, IC an excellent electrical functionality.

### Examples of Comparative Experiments

### Example 1

### Preparation of the Aqueous Polishing Compositions 1 to 6

For the preparation of the aqueous polishing compositions 1 to 6, ceria (average particle size d₅₀ of 120 to 140 Nm as determined by dynamic laser light scattering), polyethylene glycol (PEG₁₀ₖ; weight average molecular weight: 10,000), sodium hexametaphosphate (PP; weight ratio of ceria to PP = 200, hereinafter designated as PP₂₀₀) were dispersed or dissolved in ultrapure water. The amounts used are compiled in the Table 1.

**Table 1: The Compositions of the Aqueous Polishing Compositions 1 to 6**

| Composition No. | Ceria/% by weight | PEG₁₀ₖ/% by weight | PP₂₀₀ | pH |
|---|---|---|---|---|
| 1 (comparison) | 0.5 | - | - | 5.5 |
| 2 (comparison | 0.5 | 0.01 | - | 5.5 |
| 3 (comparison) | 0.5 | 0.1 | - | 5.5 |
| 4 (comparison) | 0.5 | - | + | 6.7 |
| 5 (invention) | 0.5 | 0.01 | + | 6.7 |
| 6 (invention) | 0.5 | 0.1 | + | 6.7 |

### Examples 2 and 3 and Comparative Examples C1 to C4

### CMP of Polysilicon Layers on Silicon Semiconductor Wafers

The composition No. 5 of example 1 was used for the example 2. The composition No. 6 of the example 1 was used for the example 3.

The compositions 1 to 4 of the example 1 were used for the comparative experiments C1 to C4 respectively.

Hereinafter, the CMP process parameters were used:
- Polishing apparatus:Strasbaugh 6EGnHance (rotary type):
- platen speed: 90 rpm;
- carrier speed: 70 rpm;
- IC 1000/Suba 400 K-groove polishing pad manufactured by Rohm & Haas;
- in situ conditioning using S60 3M diamond conditioner;
- slurry flow rate: 200 ml/min;
- substrates: 200 mm thermal oxide, PETEOS, silicon nitride and polysilicon wafers;
- down force: 3.5 psi (240 mbar);
- polishing time: 1 minute.

The polysilicon material removal rate MRRs were measured by laser interferometry (FilmTek™ 2000) at one site in the center of the polysilicon wafer (site 1) and at 4 sites placed around site 1 at equal distance near the edge of the wafer (sites 2 to 5).

The sites exhibiting a higher MRR are hereinafter referred to as "hot spots".

The Table 2 gives an overview over the MRRs obtained.

**Table 2: Polysilicon Material Removal Rates MRRs Occurance of Hot Spots**

| Example Comparative Experiment No. | MRR^{a} Site 1 | MRR^{a} Site 2 | MRR Site 3 | MRR Site 4 | MRR Site 5 | Site of Hot Spots | Range/ 10⁻¹⁰m (Å) | Average MRR |
|---|---|---|---|---|---|---|---|---|
| | 10⁻¹⁰ m/min * | 10⁻¹⁰ m/min * | 10⁻¹⁰ m/min * | 10⁻¹⁰ m/min * | 10⁻¹⁰ m/min * | | | 10⁻¹⁰ m/min * |
| C1 | 519 | 539 | 525 | 524 | 535 | - | 20 | 528 |
| C2 | 238 | 73 | 72 | 75 | 61 | 1 | 177 | 104 |
| C3 | 41 | 47 | 210 | 45 | 52 | 3 | 169 | 79 |
| C4 | 44 | 66 | 62 | 76 | 64 | - | 32 | 62 |
| 2 | 20 | 21 | 18 | 19 | 21 | - | 3 | 20 |
| 3 | 18 | 16 | 17 | 18 | 19 | - | 3 | 18 |

| | | | | | | | | |
|---|---|---|---|---|---|---|---|---|
| * 1 x 10⁻¹⁰ m/min = 1 Å/min | | | | | | | | |

The results of Table 2 make apparent that the polysilicon MRR was very high when the composition contained ceria only. The addition of PEG₁₀ₖ decreased the average MRR. However, a nonuniform removal of polysilicon was observed as evidenced by the appearance of hot spots. An increased concentration of PEG₁₀ₖ lead to a decrease of the range and the MRR. The addition of PP₂₀₀ also caused a decrease in the MRR, which can be suppressed by the synergism of PEG₁₀ₖ and PP₂₀₀.

In addition to this, the number of particles absorbed on the wafers was significantly lower in the case of the experiments 2 and 3 than in the case of the comparative experiments.

### Examples 4 and 5

### The Selectivity of Aqueous Polishing Compositions Containing PP₂₀₀ and PEG₁₀ₖ

For the example 4, the aqueous polishing composition 5 of the example 1 was used.

For the example 5, a polishing composition containing 0.25% by weight ceria, 0.05% by weight PEG₁₀ₖ and PP₂₀₀ was used.

The MRRs of thermal oxide (TOX), PETEOS, silicon nitride and polysilicon wafers were determined as described. The MRRs obtained are compiled in the Table 3.

**Table 3: MRRs of Thermal Oxide (TOX), PETEOS, Silicon Nitride (SiN) and Polysilicon (PSi) Wafers**

| Example No. | TOX MRR 10⁻¹⁰ m/min * | PETEOS MRR 10⁻¹⁰ m/min * | Silicon nitride MRR 10⁻¹⁰ m/min * | Polysilicon MRR 10⁻¹⁰ m/min * |
|---|---|---|---|---|
| 4 | 2471 | 3017 | 599 | 15 |
| 5 | 2074 | 3029 | 552 | 18 |

| | | | | |
|---|---|---|---|---|
| * 1 x 10⁻¹⁰ m/min = 1 Å/min | | | | |

The calculated selectivities are compiled in the Table 4.

**Table 4: The Oxide-To-Polysilicon (PSi), Oxide-To-Nitride (SiN) and Nitride-to-Polysilicon (SiN:PSi) Selectivities**

| Example No. | TOX:Psi Selectivity | PETEOS: PSi Selectivity | TOX:SiN Selectivity | PETEOS: SiN Selectivity | SiN:PSi Selectivity |
|---|---|---|---|---|---|
| 4 | 171 | 201 | 4.12 | 5 | 40 |
| 5 | 115 | 168 | 3.75 | 5.5 | 31 |

The results demonstrate that the aqueous polishing compositions were excellently suited for the CMP of semiconductor wafers containing silicon dioxide, silicon nitride and polysilicon layers. Thus, the oxide-to-polysilicon was exceptionally high, whereas the oxide-to-nitride selectivity was in the advantageous range which avoided dishing and other damages and defects in globally planarized, heterogeneous, patterned surfaces containing silicon dioxide, silicon nitride and polysilicon areas. Additionally, the nitride-to-polysilicon was far above 10.

The wafers were inspected for unwanted residual film formation after the CMP. However, no unwanted residual films were formed.

### Examples 6 to 9

The Selectivity of Aqueous Polishing Compositions Containing 0.5% by Weight Ceria, 0.1% by Weight PEG₁₀ₖ and Varying Amounts of PP

The influence of the ceria to PP ratio on the MRRs of thermal oxide (TOX), PETEOS, silicon nitride and polysilicon wafers were determined as described. The MRRs obtained are compiled in the Table 5.

**Table 5: The Influence of the Ceria to PP Ratio on the MRRs of Thermal Oxide (TOX), PETEOS, Silicon Nitride (SiN) and Polysilicon (PSi) Wafers**

| Ex. No. | Ceria to PP Ratio | TOX MRR 10⁻¹⁰ m/min * | PETEOS MRR 10⁻¹⁰ m/min * | SiN MRR 10⁻¹⁰ m/min * | PSi MRR 10⁻¹⁰ m/min * |
|---|---|---|---|---|---|
| 6 | 400 | 3170 | 4241 | 627 | 55 |
| 7 | 200 | 2471 | 3051 | 599 | 20 |
| 8 | 100 | 1986 | 2445 | 549 | 18 |
| 9 | 50 | 1633 | 1643 | 403 | 17 |

| | | | | | |
|---|---|---|---|---|---|
| * 1 x 10⁻¹⁰ m/min = 1 Å/min | | | | | |

The calculated selectivities are compiled in the Table 6.

**Table 6: The Oxide-To-Polysilicon (PSi), Oxide-To-Nitride (SiN) and Nitride-to-Polysilicon (SiN:PSi) Selectivities**

| Example No. | TOX:Psi Selectivity | PETEOS: PSi Selectivity | TOX:SiN Selectivity | PETEOS: SiN Selectivity | SiN:PSi Selectivity |
|---|---|---|---|---|---|
| 6 | 57.6 | 77.1 | 5 | 6.7 | 11.3 |
| 7 | 123.5 | 152.5 | 4.1 | 5.1 | 29.9 |
| 8 | 110 | 135.8 | 3.6 | 4.4 | 30.5 |
| 9 | 96 | 96.6 | 4 | 4 | 23.7 |

The results demonstrate that the MRRs and the selectivities could be most advantageously adjusted by way of changing the ceria to PP ratio. Exceptionally high oxide-to-polysilicon and high nitride-to-polysilicon selectivities could be achieved, whereas the oxide-to-nitride selectivities remained in the advantageous range which avoided dishing and other damages and defects in globally planarized, heterogeneous, patterned surfaces containing silicon dioxide, silicon nitride and polysilicon areas.

## Claims

1. An aqueous polishing composition has been found, the said aqueous polishing composition comprising
(A) abrasive particles consisting of ceria which are positively charged when dispersed in an aqueous medium free from component (C) and has a pH in the range of from 3 to 9 as evidenced by the electrophoretic mobility; wherein the abrasive particles consisting of ceria may contain minor amounts of other rare earth metal oxides
(B) at least one water-soluble polymer selected from the group consisting of linear and branched alkylene oxide homopolymers and copolymers; and
(C) at least one anionic phosphate dispersing agent,
wherein the composition contains the water-soluble polymer (B) in amounts of from 0.001 to 5% by weight.

2. The aqueous polishing composition according to claim 1, **characterized in that** the abrasive particles (A) consist of ceria.

3. The aqueous polishing composition according to claim 1 or 2, **characterized in that** it contains, based on the complete weight of the polishing composition, 0.005 to 10% by weight of the abrasive particles (A).

4. The aqueous polishing composition according to anyone of the claims 1 to 3, **characterized in that** the linear and branched alkylene oxide homopolymers and copolymers (B) are selected from the group consisting of ethyleneoxide and propyleneoxide homopolymers and copolymers.

5. The aqueous polishing composition according to claim 4, **characterized in that** it contains polyethylene glycol PEG as the ethyleneoxide homopolymer (B).

6. The aqueous polishing composition according to anyone of the claims 1 to 5, **characterized in that** the anionic phosphate dispersing agent (C) is selected from the group of water-soluble condensed phosphates.

7. The aqueous polishing composition according to claim 6, **characterized in that** the water-soluble condensed phosphate (C) is selected from the group consisting of metaphosphates of the general formula I:
[M⁺ₙ(PO₃)ₙ] (I);
and polyphosphates of the general formula II and III:
M⁺ₙPₙO₃ₙ₊₁ (II);
M⁺H₂PₙO₃ₙ₊₁ (III);
wherein M is ammonium, sodium and potassium and the index n is from 2 to 10,000.

8. The aqueous polishing composition according to anyone of the claims 1 to 7, **characterized in that** it contains at least one pH-adjusting agent or buffering agent (E) different from the components (A), (B) and (C).

9. The aqueous polishing composition according to anyone of the claims 1 to 8, **characterized in that** pH value of the composition is from 3 to 10.

10. A process for polishing substrates for electrical, mechanical and optical devices by contacting the substrate at least once with an aqueous polishing composition and polishing the substrate material until the desired planarity is achieved, **characterized in that** the aqueous polishing composition according to anyone of the claims 1 to 9 is used.

11. The process according to claim 10, **characterized in that** the substrates comprise at least one layer containing or consisting of at least one silicon oxide dielectric material and at least one layer containing or consisting of polysilicon, and the oxide-to-polysilicon selectivity is greater than 50.

12. The process according to claim 11, **characterized in that** the substrate material additionally comprises at least one layer containing or consisting of silicon nitride, and the oxide-to-nitride selectivity is in the range of from 3 to 6.

13. The process according to anyone of the claims 10 to 12, **characterized in that** the electrical devices are integrated circuit devices.

## Patentansprüche

1. Wässrige Polierzusammensetzung, wobei die wässrige Polierzusammensetzung umfasst:
(A) abrasive Partikel, die aus Ceroxid bestehen und die positiv geladen sind, wenn sie in einem wässrigen Medium dispergiert sind, das frei von der Komponente (C) ist und einen pH-Wert in dem Bereich von 3 bis 9 aufweist, wie gezeigt durch elektrophoretische Mobilität; wobei die abrasiven Partikel, die aus Ceroxid bestehen, geringe Mengen an anderen Seltenerdmetalloxiden enthalten können;
(B) wenigstens ein wasserlösliches Polymer ausgewählt aus der Gruppe bestehend aus linearen und verzweigten Alkylenoxid-Homopolymeren und -Copolymeren; und
(C) wenigstens ein anionisches Phosphat-Dispergiermittel,
wobei die Zusammensetzung das wasserlösliche Polymer (B) in Mengen von 0,001 bis 5 Gew.-% enthält.

2. Wässrige Polierzusammensetzung gemäß Anspruch 1, **dadurch gekennzeichnet, dass** die abrasiven Partikel (A) aus Ceroxid bestehen.

3. Wässrige Polierzusammensetzung gemäß Anspruch 1 oder 2, **dadurch gekennzeichnet, dass** sie, bezogen auf das Gesamtgewicht der Polierzusammensetzung, 0,005 bis 10 Gew.-% an den abrasiven Partikeln (A) enthält.

4. Wässrige Polierzusammensetzung gemäß einem der Ansprüche 1 bis 3, **dadurch gekennzeichnet, dass** die linearen und verzweigten Alkylenoxid-Homopolymere und -Copolymere (B) ausgewählt sind aus der Gruppe bestehend aus Ethylenoxid- und Propylenoxid-Homopolymeren und -Copolymeren.

5. Wässrige Polierzusammensetzung gemäß Anspruch 4, **dadurch gekennzeichnet, dass** sie Polyethylenglycol PEG als das Ethylenoxid-Homopolymer (B) enthält.

6. Wässrige Polierzusammensetzung gemäß einem der Ansprüche 1 bis 5, **dadurch gekennzeichnet, dass** das anionische Phosphat-Dispergiermittel (C) ausgewählt ist aus der Gruppe von wasserlöslichen kondensierten Phosphaten.

7. Wässrige Polierzusammensetzung gemäß Anspruch 6, **dadurch gekennzeichnet, dass** das wasserlösliche kondensierte Phosphat (C) ausgewählt ist aus der Gruppe bestehend aus Metaphosphaten der allgemeinen Formel I:
[M⁺ₙ(PO₃)ₙ] (I);
und Polyphosphaten der allgemeinen Formel II und III:
M⁺ₙPₙO₃ₙ₊₁ (II);
M⁺H₂PₙO₃ₙ₊₁ (III);
wobei M Ammonium, Natrium und Kalium ist und der Index n von 2 bis 10.000 beträgt.

8. Wässrige Polierzusammensetzung gemäß einem der Ansprüche 1 bis 7, **dadurch gekennzeichnet, dass** sie wenigstens ein pH-Einstellmittel oder Puffermittel (E), das von den Komponenten (A), (B) und (C) verschieden ist, enthält.

9. Wässrige Polierzusammensetzung gemäß einem der Ansprüche 1 bis 8, **dadurch gekennzeichnet, dass** der pH-Wert der Zusammensetzung von 3 bis 10 beträgt.

10. Verfahren zum Polieren von Substraten für elektrische, mechanische und optische Vorrichtungen durch wenigstens einmaliges Inkontaktbringen des Substrats mit einer wässrigen Polierzusammensetzung und Polieren des Substratmaterials, bis die gewünschte Planarität erzielt ist, **dadurch gekennzeichnet, dass** die wässrige Polierzusammensetzung gemäß einem der Ansprüche 1 bis 9 verwendet wird.

11. Verfahren gemäß Anspruch 10, **dadurch gekennzeichnet, dass** die Substrate wenigstens eine Schicht umfassen, die wenigstens ein dielektrisches Siliciumoxidmaterial enthalten oder daraus bestehen, und wenigstens eine Schicht, die Polysilicium enthalten oder daraus bestehen, und dass die Oxid-zu-Polysilicium-Selektivität höher als 50 ist.

12. Verfahren gemäß Anspruch 11, **dadurch gekennzeichnet, dass** das Substratmaterial zusätzlich wenigstens eine Schicht enthält, die Siliciumnitrid enthält oder daraus besteht, und dass die Oxid-zu-Nitrid-Selektivität in dem Bereich von 3 bis 6 liegt.

13. Verfahren gemäß einem der Ansprüche 10 bis 12, **dadurch gekennzeichnet, dass** die elektrischen Vorrichtungen integrierte Schaltungsvorrichtungen sind.

## Revendications

1. Composition de polissage aqueuse, ladite composition de polissage aqueuse comprenant :
(A) des particules abrasives constituées d'oxyde de cérium qui ont une charge positive lorsqu'elles sont dispersées dans un milieu aqueux exempt de constituant (C) et ayant un pH de 3 à 9, mise en évidence par la mobilité électrophorétique ; dans laquelle les particules abrasives constituées d'oxyde de cérium peuvent contenir des quantités mineures d'autres oxydes de métaux du groupe des terres rares ;
(B) au moins un polymère hydrosoluble sélectionné dans le groupe constitué d'homopolymères et de copolymères linéaires et ramifiés d'oxyde d'alkylène ; et
(C) au moins un dispersant de type phosphate anionique,
la composition contenant le polymère hydrosoluble (B) dans des quantités de 0,001 à 5 % en poids.

2. Composition de polissage aqueuse selon la revendication 1, **caractérisée en ce que** les particules abrasives (A) se composent d'oxyde de cérium.

3. Composition de polissage aqueuse selon la revendication 1 ou 2, **caractérisée en ce qu'**elle contient, relativement au poids total de la composition de polissage, 0,005 à 10 % en poids des particules abrasives (A).

4. Composition de polissage aqueuse selon l'une quelconque des revendications 1 à 3, **caractérisée en ce que** les homopolymères et copolymères linéaires et ramifiés d'oxyde d'alkylène (B) sont sélectionnés dans le groupe constitué d'homopolymères et de copolymères d'oxyde d'éthylène et d'oxyde de propylène.

5. Composition de polissage aqueuse selon la revendication 4, **caractérisée en ce qu'**elle contient du polyéthylène glycol PEG comme homopolymère d'oxyde d'éthylène (B).

6. Composition de polissage aqueuse selon l'une quelconque des revendications 1 à 5, **caractérisée en ce que** le dispersant de type phosphate anionique (C) est sélectionné dans le groupe constitué de phosphates condensés hydrosolubles.

7. Composition de polissage aqueuse selon la revendication 6, **caractérisée en ce que** le phosphate condensé hydrosoluble (C) est sélectionné dans le groupe constitué de métaphosphates ayant la formule générale I :
[M⁺ₙ(PO₃)ₙ] (I) ;
et de polyphosphates ayant les formules générales II et III :
M⁺ₙPₙO₃ₙ₊₁ (II) ;
M⁺H₂PₙO₃ₙ₊₁ (III) ;
dans lesquelles M est l'ammonium, le sodium et le potassium et l'indice n vaut de 2 à 10 000.

8. Composition de polissage aqueuse selon l'une quelconque des revendications 1 à 7, **caractérisée en ce qu'**elle contient au moins un agent d'ajustement du pH ou agent tampon (E) différent des constituants (A), (B) et (C).

9. Composition de polissage aqueuse selon l'une quelconque des revendications 1 à 8, **caractérisée en ce que** la valeur de pH de la composition est de 3 à 10.

10. Procédé de polissage de substrats pour des dispositifs électriques, mécaniques et optiques par mise en contact du substrat au moins une fois avec une composition de polissage aqueuse et polissage du matériau du substrat jusqu'à ce que la planéité souhaitée soit obtenue, **caractérisé en ce que** la composition de polissage aqueuse selon l'une quelconque des revendications 1 à 9 est utilisée.

11. Procédé selon la revendication 10, **caractérisé en ce que** les substrats comprennent au moins une couche contenant ou consistant en au moins un matériau diélectrique d'oxyde de silicium et au moins une couche contenant ou consistant en un polysilicium, et la sélectivité oxyde-polysilicium est supérieure à 50.

12. Procédé selon la revendication 11, **caractérisé en ce que** le matériau du substrat comprend en outre au moins une couche contenant ou consistant en un nitrure de silicium, et la sélectivité oxyde-nitrure est de 3 à 6.

13. Procédé selon l'une quelconque des revendications 10 à 12, **caractérisé en ce que** les dispositifs électriques sont des dispositifs à circuits intégrés.
